# EUROPEAN PATENT APPLICATION

(11) **EP 0 687 747 A1**
(43) Date of publication of application: **20.12.1995**
(21) Application number: 95303426.1
(22) Date of filing: 23.05.1995
(51) Int. Cl.: C23C 16/26, C04B 37/00, C30B 25/00, C30B 25/02

(54) **Apparatus and method for chemical vapor deposition of diamond**

(30) Priority: 15.06.1994 US 260434
(71) Applicant: GENERAL ELECTRIC COMPANY, Schenectady, NY 12345 (US)
(72) Inventor: Anthony, Thomas Richard, Schenectady, New York 12309 (US); Spiro, Cifford Lawrence, Niskayuna, New York 12309 (US); Fleischer, James Fulton, Scotia, New York 12302 (US)
(74) Representative: Szary, Anne Catherine

(57) **Abstract**

Diamond mosaics are prepared by chemical vapor deposition of an adherent layer of diamond in a recess, preferably V-shaped, formed by the edges of one or more diamond substrates. Deposition is preferably filament activated, with the filament being moved relative to the substrates to maintain it at a distance of 1 mm. or less from the surfaces receiving the deposited diamond.

## Description

This invention relates to the chemical vapor deposition of diamond, and more particularly to the formation of diamond mosaics thereby.

Diamond production by chemical vapor deposition (hereinafter sometimes "CVD") is well known. It involves activation at relatively low pressure of a mixture of hydrogen and a gaseous hydrocarbon followed by passage of the gaseous mixture into contact with a substrate. The hydrogen gas is converted to atomic hydrogen which reacts with the hydrocarbon to form active gaseous carbon species, which in turn are adsorbed on the substrate and react to form polycrystalline diamond. A number of types of activation may be employed, including thermal activation which, in the "filament method", is typically effected by means of one or more wires or filaments heated, under prior art conditions, to a temperature in the range of about 2000-2100°C.

While the CVD method can be used to produce diamond sheets with dimensions of 2-3 cm. on a side, the production of stable sheets of larger size has previously been difficult or impossible. Even when it is possible to prepare such sheets, they crack easily and therefore cannot be employed unless cut into smaller pieces. Thus, recent requests by the Federal Government for bids on CVD diamond sheets 1 mm. thick and about 10 cm. in length and width received no responses.

It is also of interest to provide a method for joining two relatively small gem quality diamonds to produce a larger diamond, especially one having large single crystal areas. This is true because the value of gem quality diamonds increases substantially with increasing size.

The present invention is as claimed in the claims.

The present invention provides a method for joining two or more diamond sheets or other articles together with CVD diamond, to form a mosaic. Said method may be employed to join articles of CVD diamond or other types of diamond, including gem quality stones. Therefore, diamond articles of increased size, either polycrystalline or having large single crystal regions, may be obtained.

One aspect of the invention is a method for producing a mosaic which comprises depositing an adherent layer of diamond by chemical vapor deposition in a recess formed by the edges of one or more substrates of diamond. Another aspect is diamond mosaics comprising an adherent layer of diamond in at least one such recess.

Embodiments of the invention will now be described, by way of example only, with reference to the accompanying drawings, of which :

FIGURES 1-5 are schematic sectioned end-views showing application of the method of this invention to various diamond substrate configurations and;

FIGURES 6-7, respectively, are a cutaway view and a cross section view along the lines 7-7 of FIGURE 6 of apparatus suitable for performing said method.

The method of this invention may be employed with any known procedure for forming CVD diamond. Such procedures include filament activation and activation by other means, such as by microwave radiation. It is necessary, however, to limit the area of diamond deposition to the desired region, principally the aforementioned recess. Filament activation is therefore preferred by reason of the ease of limiting the deposition region thereby.

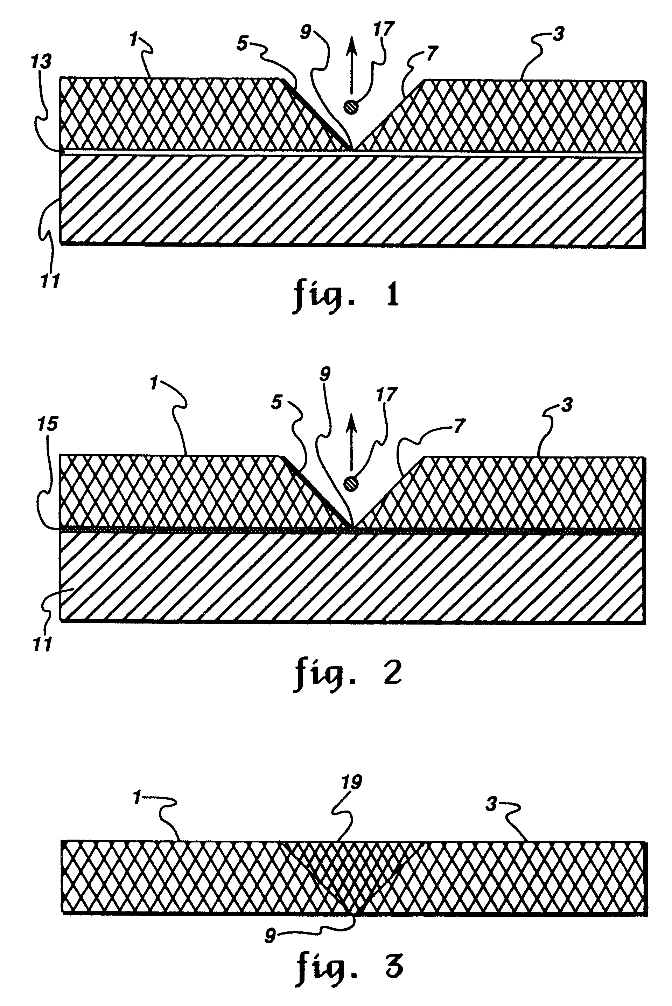

FIGURES 1-3 are illustrative of various alternatives for one embodiment of the invention, in which the deposited diamond provides a bond between two coplanar diamond sheets 1 and 3 having beveled edges 5 and 7 so as to form a V-shaped edge configuration, said edges making contact at 9.

In most instances, it is preferred to prevent overheating of the diamond substrates by placing them in proximity to a heat sink 11, which may be cooled as by a transmission of water through passages therein or serpentine piping attached thereto. It is generally found that an adequate rate of diamond deposition requires that the substrates be spaced from the heat sink. Spacing may be provided, for example, by shims adapted to separate the substrates from the heat sink by about 1 mm., the gap between the substrates and heat sink being shown at 13 in FIGURE 1, by insertion of a diamond sheet as a spacer 15 between the heat sink and substrates as shown in FIGURE 2, or by providing a recess in the heat sink as described hereinafter.

Filament 17, shown in FIGURES 1 and 2, when heated activates a mixture of hydrogen and hydrocarbon gas which is passed into the CVD vessel through suitable piping. Upon activation of said gas mixture, polycrystalline diamond deposits on surfaces 5 and 7, joining the two initially in the vicinity of junction point 9 to bridge substrates 1 and 3. Under typical diamond deposition conditions, filament 17 is heated to a temperature on the order of 1800-2500°C and the gas mixture comprises about 1-5% and preferably about 1.5% by volume hydrocarbon, ordinarily methane, based on total gases.

In order to effect rapid deposition of diamond, it is preferred to maintain the distances between filament 17 and surfaces 5 and 7 at 1 mm. or less. At such distances, diamond forms so fast that the buildup thereof on each surface may contact the filament.

To prevent such contact and other problems, it is strongly preferred to move filament 17 relative to surfaces 5 and 7 as shown by the arrows in FIGURES 1 and 2. Movement may be of the filament, substrates or both. A suitable apparatus for withdrawing the filament at the rate of diamond deposition is shown in the aforementioned copending application

EP 95300514.7, the disclosure of which are incorporated by referenece herein and copy of which is filed for inclusion on the European Patent Office file for this application.

Upon withdrawing filament 17 a suitable distance, the recess bounded by edges 5 and 7 of substrates 1 and 3, respectively, may be completely filled with diamond, illustrated by insert 19 shown in FIGURE 3. Thus, a unitary mosaic is formed by substrates 1 and 3 and said insert, which provides an adhesive bridge.

In most instances, each of substrates 1 and 3 is a sheet of polycrystalline diamond, typically produced by the CVD method. It is also within the scope of the invention, however, for substrates 1 and 3 to be single crystal diamond, either naturally occurring or synthetically produced. Said substrates may also be synthetic polycrystalline diamond prepared by the high pressure, high temperature method.

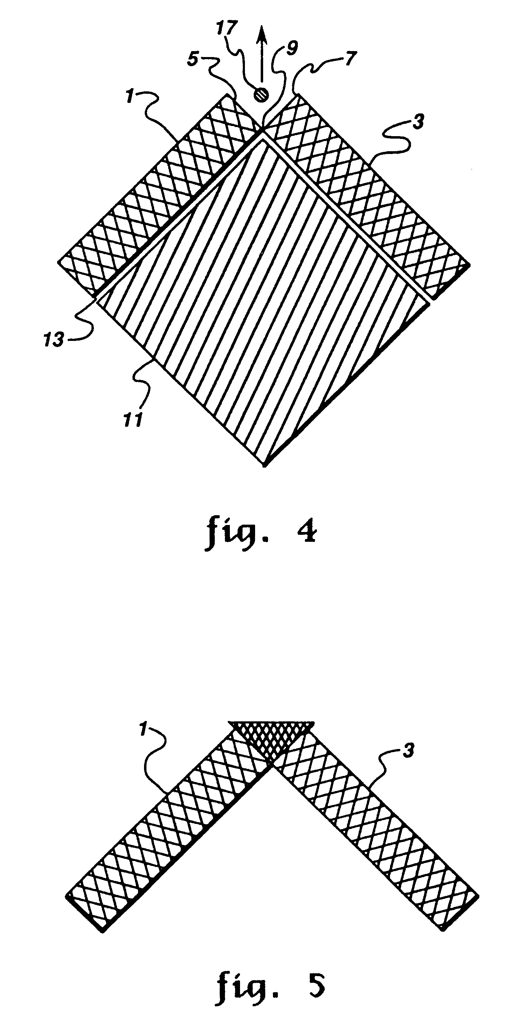

In the embodiment of the invention shown in FIGURES 4 and 5, diamond substrates 1 and 3 are at right angles to each other and edges 5 and 7 are perpendicular to the surfaces of the substrates rather than beveled. FIGURE 4 shows a space 13 between substrates 1 and 3 and heat sink 11, but a diamond sheet may be interposed therein as shown in FIGURE 2. The product (FIGURE 5) is an angled article with a triangular insert providing adhesion between the substrates.

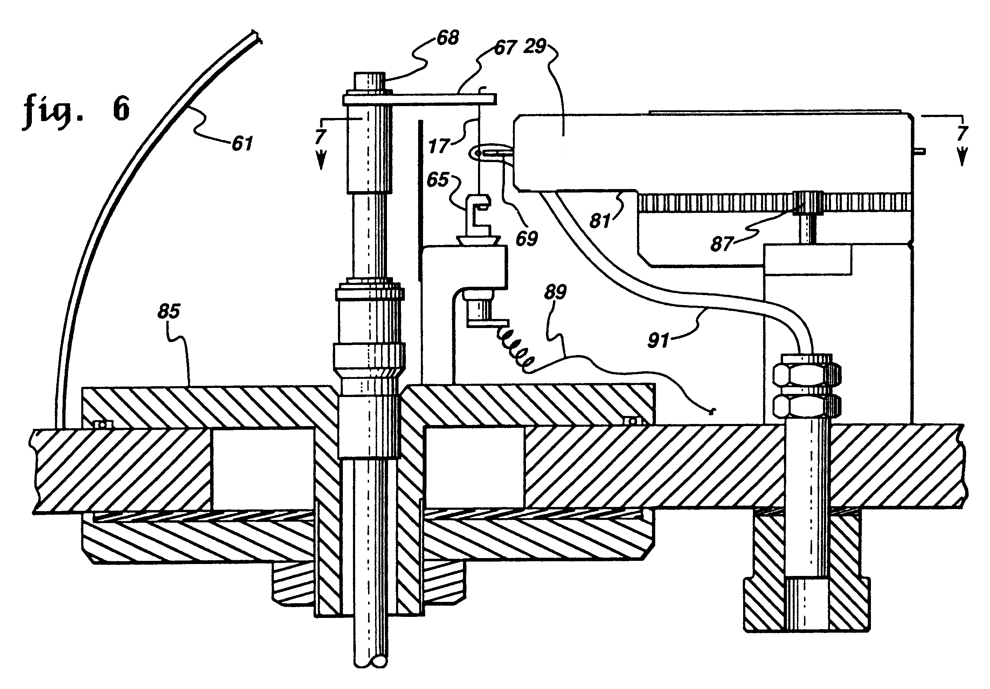

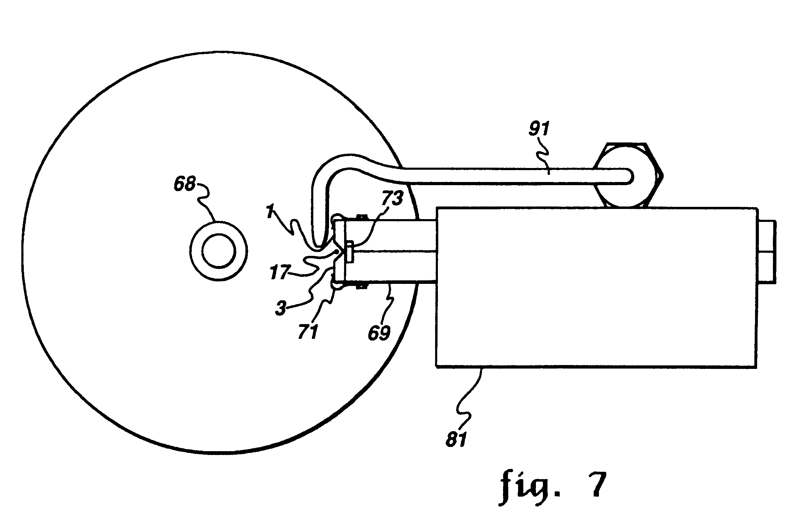

FIGURES 6 and 7 depict apparatus suitable for performing the method of the invention. The diamond-producing elements of said apparatus are enclosed in enclosure 61 (cut away because of lack of space) which is vacuum-tight and thus capable of being maintained at reduced pressure, typically on the order of 10 torr. Appropriate portions of the apparatus which are present in enclosure 61 are constructed of heat-resistant materials, as necessary to withstand exposure to filament temperatures up to about 2500°C and substrate temperatures up to about 1000°C. Quartz, for example, is an illustrative non-conductive heat-resistant material suitable for said enclosure.

Filament 17 is supported by clamp 65 and clamp 67 attached to post 68. Said filament is made of a heat-resistant material such as metallic tungsten, tantalum, molybdenum or rhenium. Because of its relatively low cost and particular suitability, tungsten is often preferred. As shown, filament 17 is in a vertical position, but it is within the scope of the invention for said filament to be horizontal or in another position.

Diamond sheets 1 and 3 are held in place on heat sink 69 by clips, one of which is designated 71. Heat sink 71 has recess 73 therein, as an alternative means of preventing overheating.

Substrate holder 81 is capable of continuous movement relative to filament 17. This may be accomplished by making substrate holder 81, the filament assembly (including filament 17, clamps 65 and 67 and post 68), or both, moveable units. In the embodiment shown in FIGURE 6, both are capable of movement, the filament assembly via sliding stage 85 and substrate holder 81 via rack-and-piston system 87.

Filament 17 is equipped with electrical connections to provide heating thereof. As shown in FIGURE 1, these include lead 89 and a further lead (not shown) connected to post 68.

Gas is supplied to the CVD apparatus for diamond growth via gas line 91, which terminates at a location proximate to filament 17 and the juncture of the two diamond sheets

In operation for chemical vapor deposition of diamond to form a mosaic, the interior of enclosure 61 is brought to the desired subatmospheric pressure. Filament 17 and diamond sheets 1 and 3 are maintained in the depicted positions and at the aforementioned distance, and filament 17 is heated to a temperature on the order of 1800-2500°C. A mixture of hydrogen and a hydrocarbon gas, typically methane, typically comprising about 1-5% and preferably about 1.5% by volume hydrocarbon based on total gases, is supplied through line 91. Said gases are activated by said heated filament, whereupon the recess between said sheets is filled with diamond.

If diamond formation were allowed to proceed without movement of the diamond sheets or filament, the diamond formed on said sheets would ultimately contact the filament with possible catastrophic results. To avoid this, diamond sheets 1 and 3, filament 17 or both are moved to maintain the aforementioned distance between the filament and the diamond formed. Such movement may be achieved manually to a degree determined by visual observation, as with a video camera. However, it is generally preferred to employ computer means to program the movement in accordance with the experimentally determined rate of diamond formation. For this purpose, the actual distance from the filament to the diamond sheets or diamond being formed can be determined by laser scanning. Suitable computer means and programs therefor can easily be developed by those skilled in the art.

The invention is illustrated by an example in which a single grooved piece of diamond, 12 mm. x 10 mm x 330 microns, was employed as a substrate. A perpendicular groove with a width of 0.6 mm. and a depth of 7 mm. was cut in the long side, and the edges of the groove were beveled.

The diamond substrate was mounted in a molybdenum bracket over a heat sink from which it was separated by a diamond spacer 101 microns thick. The assembly was placed in a vacuum-tight enclosure at a distance of about 1 mm. from a tungsten filament 28 mm. long and 0.4 mm. in diameter. The enclosure was evacuated to a pressure of 60 torr, the filament was heated to about 2100°C and hydrogen and methane were introduced at 296 and 4.5 cc./minute, respectively, to produce a mixture of 98.5% (by volume) hydrogen and 1.5% methane.

Diamond deposition in this system was effected for 19-1/2 hours, with the distance between the substrate and the filament being monitored with a video camera and the filament being withdrawn so as to maintain a 1-mm. distance from the diamond being deposited. At the end of the deposition period, the filament power was gradually reduced to zero and the assembly was cooled and disassembled. A solid adherent region of diamond was observed in the groove, joining the two sides thereof.

## Claims

1. A method for producing a mosaic which comprises depositing an adherent layer of diamond by chemical vapor deposition in a recess formed by the edges of one or more substrates of diamond.

2. A method according to claim 1 wherein chemical vapor deposition is effected by hot filament activation of a mixture of hydrogen and a hydrocarbon gas.

3. A method according to claim 2 wherein the distances between the filament and the surfaces on which the diamond is to be deposited is maintained at 1 mm. or less.

4. A method according to claim 1 wherein the substrates are of polycrystalline diamond.

5. A method according to claim 4 wherein at least two substrates are employed.

6. A method according to claim 5 wherein the substrates are coplanar and the diamond-receiving edges thereof are beveled in a V-shaped configuration.

7. A method according to claim 5 wherein the substrates are at right angles to each other and have diamond-receiving edges perpendicular to their surfaces.

8. A method according to claim 1 wherein the substrates are in proximity to a heat sink.

9. A method for producing a joined diamond sheet by chemical vapor deposition of diamond which comprises:
positioning at least two diamond sheets to be joined in a V-shaped edge configuration with an edge of each sheet facing at least one filament at a distance of each sheet from said filament up to about 1 mm.,
heating said filament to a temperature in the range of about 1800-2500°C,
maintaining said sheets at a pressure lower than atmospheric and passing a mixture of hydrogen and a hydrocarbon gas into contact with said filament and sheets, whereby an adherent layer of diamond forms on the edges of said sheets, and
moving said sheets relative to said filament to maintain a distance of up to about 1 mm. between said filament and the diamond formed on said sheets.

10. A diamond mosaic comprising an adherent layer of diamond deposited in a recess formed by the edges of one or more substrates of diamond.
